# EUROPEAN PATENT APPLICATION

(11) **EP 4 422 073 A1**
(43) Date of publication of application: **28.08.2024**
(21) Application number: 23158679.3
(22) Date of filing: 27.02.2023
(51) Int. Cl.: H03K 5/1534

(54) **LOGIC CIRCUIT, RESTRAINT CONTROL SYSTEM, AND VEHICLE**

(71) Applicant: Veoneer Sweden Safety Systems AB, 10302 Stockholm (SE)
(72) Inventor: POSADA, Esteban, 95800 Cergy-Pontoise (FR); DOBROVOLSCHI, Victor, 95800 Cergy-Pontoise (FR)
(74) Representative: Reichert & Lindner Partnerschaft Patentanwälte

(57) **Abstract**

A logic circuit (1) with plural input contacts (2) has a sub-circuit (5) for signal edge detection. The sub-circuit (5) has a single signal input (4) coupled to each of the input contacts (2) and produces an output signal (6) in response to a signal edge at the single signal input (4). A restraint control system (110) for a vehicle (100) is configured to trigger one or more restraints in response to the output signal (6). In a vehicle (100) one or more sensors (121, 122) are coupled to the restraint control system (110); some of the sensors (122) may be coupled to the restraint control system (110) via a data processing device (130).

## Description

The invention relates to a logic circuit, as may for example be used in a restraint control system of a vehicle. The invention also relates to a corresponding restraint control system and vehicle.

In various use cases throughout differing fields of technology a processing of signals via a logic of the "OR"-type is desirable, wherein, however, the presence of individual signals at the input contacts of the "OR"-logic shall remain detectable, instead of being submerged into the single output of the "OR"-logic. An example in modern vehicles are distributed safety systems, the operation, or firing, of which needs to be detected individually (rather than detecting only that at least one of the systems has fired) or is triggered by each of plural possible signals (like e.g., produced in response to data captured by sensors), wherein nonetheless the presence of each signal is to be detected.

A classical DC-based "OR"-gate is not capable of providing this functionality.

Therefore, it is the object of the invention to provide a logic circuit to overcome this limitation.

This object is achieved by a logic circuit according to claim 1. Claim 4 relates to a corresponding restraint control system and claim 5 to a corresponding vehicle. The dependent claims relate to advantageous embodiments.

The logic circuit according to the invention comprises a plurality of input contacts. Via these input contacts the signals to be processed by the logic circuit are provided as input to the circuit. The logic circuit furthermore has a sub-circuit for signal edge detection. This sub-circuit has a single signal input, the single signal input is in electrical contact with each of the plurality of input contacts. The sub-circuit is configured to produce an output signal in response to a signal edge at the single signal input. The sub-circuit thus is configured to operate as a signal edge detection circuit. According to the invention a respective high-pass filter is electrically connected between each of the input contacts and the single signal input. That is, for each of the input contacts, a signal provided to that specific input contact is passed through a high-pass filter before being applied to the single signal input of the sub-circuit.

As all input contacts of the logic circuit are in electrical contact with the single signal input of the sub-circuit for signal edge detection, an "OR"-logic behaviour of the logic circuit is achieved. The edge detection by the sub-circuit can detect the edge of a signal, in particular the edge of a step-shaped signal, but without further means would be blind to further signals arriving during the duration of a preceding signal. Such a functionality would reflect classical "OR"-gate behaviour. The high-pass filter, however, converts a step-shaped signal into a peaked signal of typically shorter duration (e.g., width at half maximum) than the duration of the initial step-shaped signal. The edge detection by the sub-circuit can detect and discriminate between individual peaks as long as the peaks do not overlap too much, and therefore can detect plural step-shaped signals at the input contacts as long as these arrive spaced apart by a minimum distance in time which may be far shorter than the duration of each of the step-shaped signals.

In an embodiment, each respective high-pass filter is realised by a capacitive coupling between the respective input contact and the single signal input. Such capacitive coupling, realised for example by a coupling capacitor, converts a step-like signal into a peak with a sharp rising edge and an exponentially decaying edge. The time-constant or decay-time of such decay determines the temporal resolution of the edge detection by the sub-circuit, i.e., the minimal temporal distance between two subsequent signals so that these two signals can still be discriminated.

In an embodiment, the logic circuit is configured to achieve a pre-defined decay-time of each signal at the single signal input. This can be achieved by choice of the capacitance of the coupling capacitor and/or by choice of resistors, more generally by suitable configuration of the high-pass filter and its connection to the single signal input of the sub-circuit.

Generally, the output signal from the sub-circuit may be further processed, for example filtered, before it is provided to further use.

A restraint control system according to the invention for a vehicle is configured for triggering one or more restraints for a passenger in case of an emergency. According to the invention the restraint control system includes a logic circuit according to the invention, as described above. The restraint control system is configured to trigger at least one of the one or more restraints in response to an output signal produced by the sub-circuit of the logic circuit.

A vehicle according to the invention includes a restraint control system according to the invention, as just described.

In an embodiment, the vehicle includes a plurality of sensors. Each input contact of the logic circuit of the restraint control system is coupled to at least one of the plurality of sensors in such a way that the respective input contact can receive signals in response to data captured by the at least one of the plurality of sensors.

In a more specific variant of this embodiment, one or more sensors of the plurality of sensors are coupled to one or more input contacts of the logic circuit via a data processing device. The data processing device is configured to receive data from the one or more sensors, process the data, and produce a signal to one or more of the input contacts of the logic circuit in dependence on the processed data.

Below, the invention and its advantages will be described in more detail with reference to the accompanying drawings.
- Figure 1: schematically shows a logic circuit according to the invention.
- Figure 2: shows an example of circuitry implementing a logic circuit according to the invention.
- Figure 3: again shows the circuitry of Fig. 2 in relation to various signals.
- Figure 4: shows a further example of circuitry implementing a logic circuit according to the invention.
- Figure 5: shows a vehicle according to the invention.

The figures show only examples of how the invention may be implemented and are not to be taken as a limitation of the invention to the specific embodiments shown.

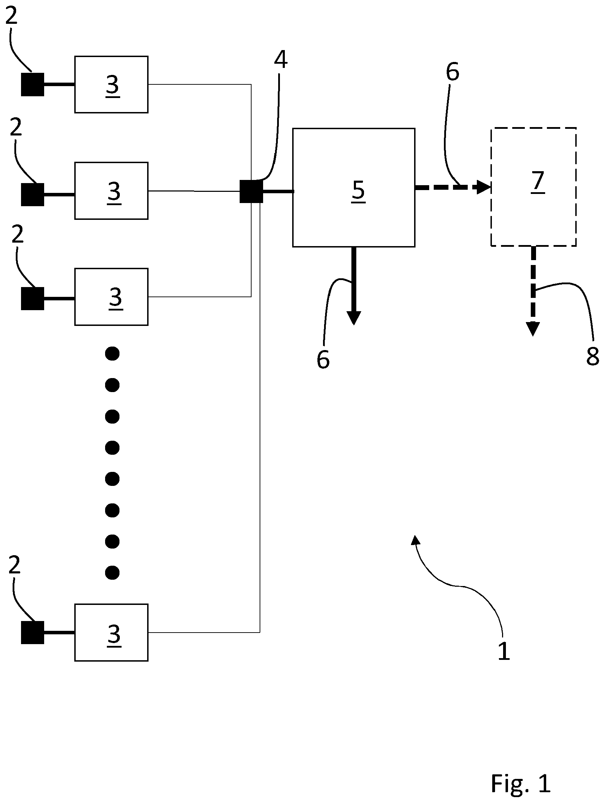

**Fig. 1** shows a logic circuit 1 according to the invention. The logic circuit 1 has a plurality of input contacts 2, each of which is electrically connected to a high-pass filter 3. All of the high-pass filters 3 are connected to a single signal input 4 of a sub-circuit 5 for signal edge detection. A signal provided at one of the input contacts 2 is subject to high-pass filtering by the corresponding high-pass filter 3. The resulting signal is provided to the single signal input 4. The sub-circuit 5 is configured to detect a signal edge in a signal provided to the single signal input 4 and to produce an output signal 6 in response to the detection of a signal edge. Depending on the deployment situation of the logic circuit 1, the output signal 6 may be available for various purposes. In an alternative, indicated in dashed lines, the output signal 6 from the sub-circuit 5 for signal edge detection is provided to a signal processing stage 7, which processes output signal 6 to produce a processed output signal 8. Depending on the deployment situation of the logic circuit 1, the processed output signal 8 may be available for various purposes. The signal processing stage 7 may for example perform a filtering operation on output signal 6.

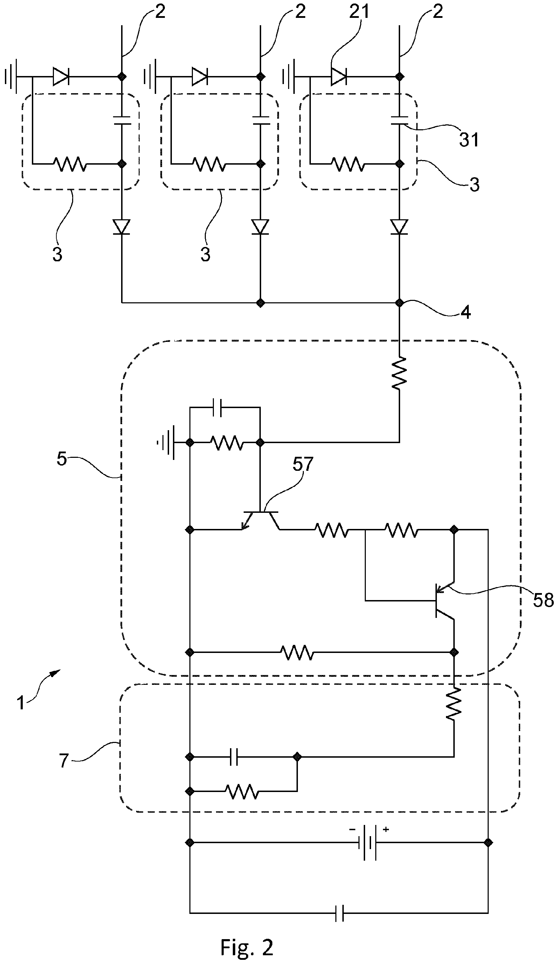

**Fig. 2** shows an example of circuitry implementing the logic circuit 1 according to the invention. In the example shown the logic circuit 1 has three input contacts 2. The high-pass filters 3 are realised as capacitive coupling via capacitor 31 between respective input contact 2 and single signal input 4. For each input contact 2, a respective diode 21 protects against a negative spike due to the capacitive coupling and contributes to protecting against wrong polarity of a signal provided at the input contact 2. The sub-circuit 5 for detecting a signal edge of a signal at the single signal input 4 includes transistors 57, 58. In the embodiment shown the logic circuit 1 includes a signal processing stage 7 following the sub-circuit 5.

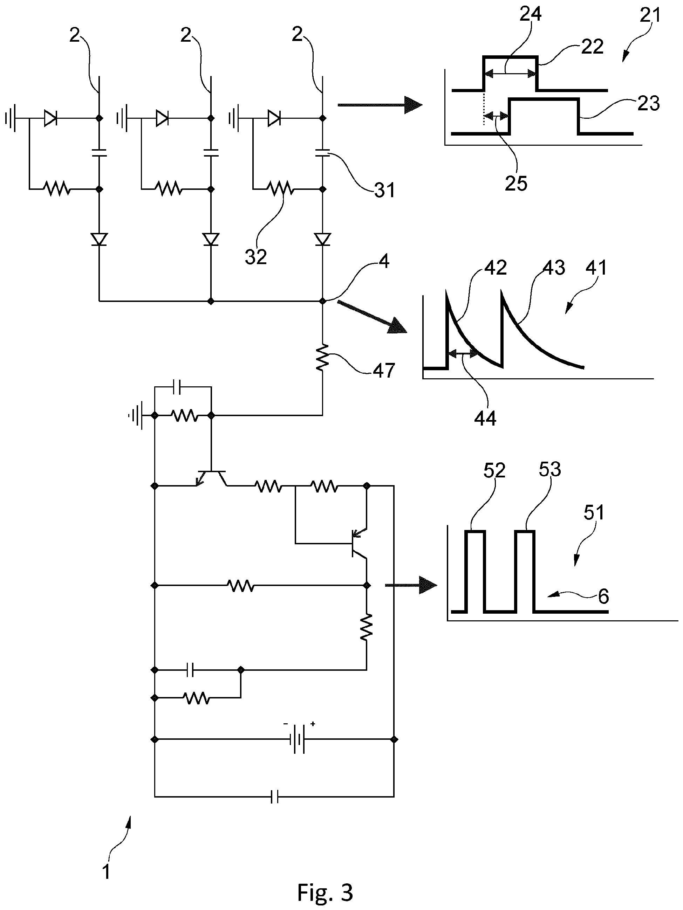

**Fig. 3** again shows the logic circuit 1 shown in Fig. 2, in relation to signals occurring at various locations within the logic circuit 1. Diagram 21 shows input signal pulses at two of the three input contacts 2. The pulses are step-shaped signals, wherein signal 22 precedes signal 23 by a temporal distance 25. This temporal distance 25 is shorter than the pulse duration 24 of signal 22, so signal 22 and signal 23 overlap. A classical DC "OR"-gate would produce the correct output "true" but could not detect signal 23 as a separate signal. Note that the step signals 22, 23 are offset against one another along the ordinate (showing signal strength) for purposes of presentation only.

Diagram 41 shows the signal at the single signal input 4. The signal has a peak 42, resulting from step signal 22, and a peak 43, resulting from step signal 23. The peaks 42, 43 have a steep rising edge followed by an exponential decay characterised by a decay-time 44.

Diagram 51 shows output signal 6 of the sub-circuit 5 for signal edge detection. Pulse 52 results from peak 42, pulse 53 results from peak 43. The pulses 52 and 53 are clearly distinct, as the signal edge detection by sub-circuit 5 can detect the rising edge of each of the two peaks 42, 43. Considering the case of shorter and shorter temporal distance 25 between signals 22 and 23 in comparison to decay-time 44 of peak 42, a situation will be reached in which the signal edge detection by sub-circuit 5 can no longer discriminate between the peaks 42 and 43, e.g., because peak 42 does not drop off below a pre-defined level before the onset of peak 43.

By choosing the capacitance of capacitor 31 and resistance of resistor 32 for each input contact 2 and choosing resistance of resistor 47, the decay-time 44 can be set. Advantageously the decay-time 44 is set to be sufficiently short so that pulses 22, 23 arriving at input contacts 2 separated by at least a pre-defined minimum temporal distance can be discriminated by sub-circuit 5. The choice of the pre-defined minimum temporal distance depends on the deployment situation of logic circuit 1. From the preceding discussion it is evident that signals 22, 23 arriving with a temporal distance shorter than such a pre-defined minimum temporal distance may not result in separate pulses 52, 53 at the output of sub-circuit 5; i.e., from the point of view of the logic circuit 1, such signals 22, 23 at the input contacts 2 are considered a single event.

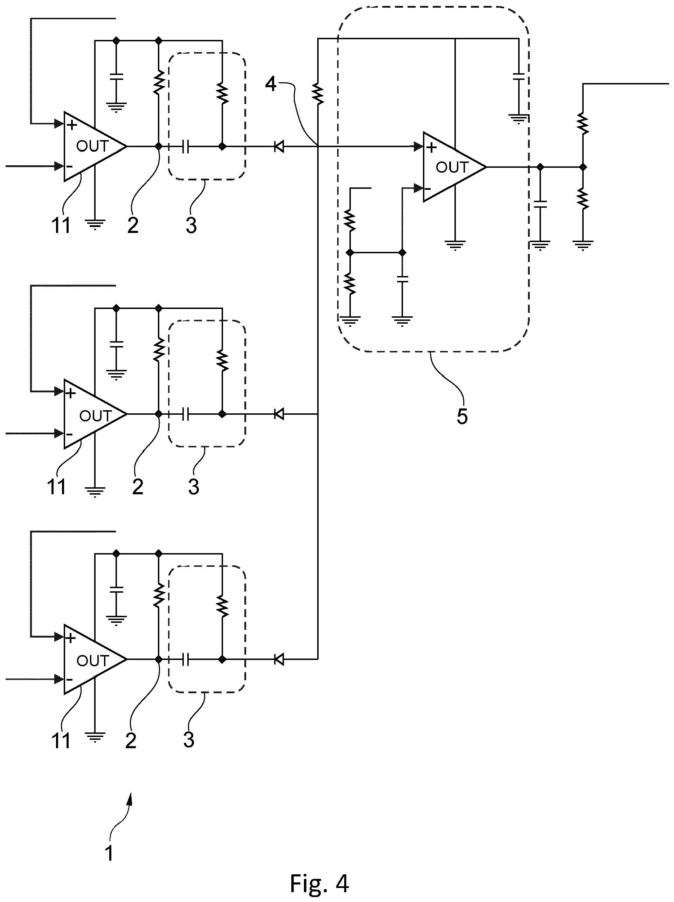

**Fig. 4** shows a further example of circuitry implementing a logic circuit 1 according to the invention. In analogy to Fig. 2 there are indicated input contacts 2, high-pass filters 3 realised by capacitive coupling, and single signal input 4 of a sub-circuit 5 for signal edge detection.

Each of the detection elements 11 is provided to detect, in a deployment situation of logic circuit 1 on board of a vehicle, the firing of a restraint and to produce a corresponding signal to the respective input contact 2 of the logic circuit 1. Detection elements as shown can also be used in the context of the circuitry shown in Fig. 2. Likewise, the circuitry of the logic circuit 1 shown in Fig. 4 can be employed without the detection elements 11 and receive suitable signals at the input contacts 2 from different sources.

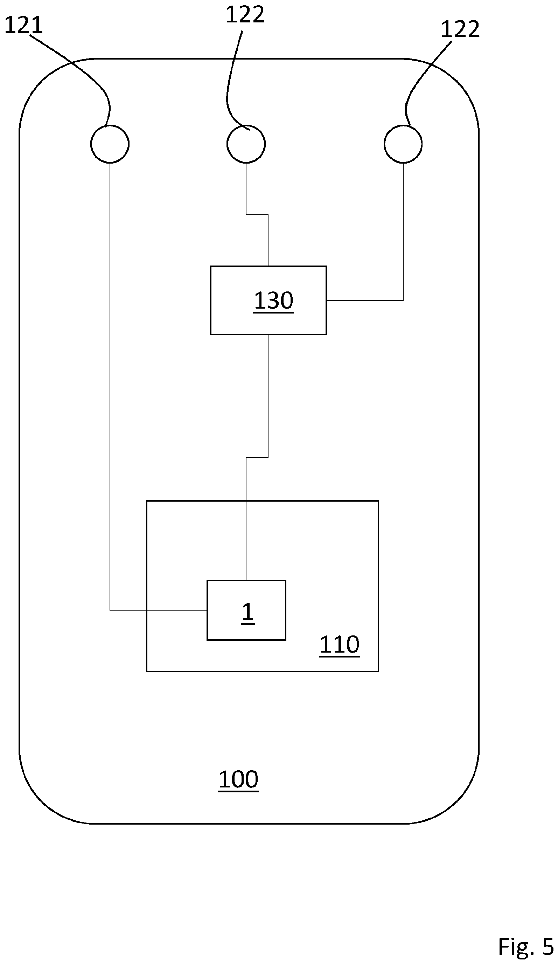

**Fig. 5** shows a vehicle 100 according to the invention with a restraint control system 110, which according to the invention has a logic circuit 1 according to the invention.

The vehicle 100 has plural sensors 121, 122. Sensor 121 provides signals directly to an input contact 2 (see Fig. 1) of logic circuit 1, sensors 122 are coupled to a data processing device 130. The data processing device 130 processes data received from sensors 122 and as result thereof provides a signal to one or more input contacts 2 of logic circuit 1. Depending on the output signal 6 (see Fig. 1) of logic circuit 1, the restraint control system 110 may trigger one or more restraints (not shown).

### List of Reference Signs

- 1: logic circuit
- 2: input contact
- 3: high-pass filter
- 4: single signal input
- 5: sub-circuit
- 6: output signal
- 7: signal processing stage
- 8: processed output signal
- 11: detection element
- 21: diagram
- 22: step signal
- 23: step signal
- 24: pulse duration
- 25: temporal distance
- 31: capacitor
- 32: resistor
- 41: diagram
- 42: peak
- 43: peak
- 44: decay-time
- 47: resistor
- 51: diagram
- 52: pulse
- 53: pulse
- 57: transistor
- 58: transistor
- 100: vehicle
- 110: restraint control system
- 121: sensor
- 122: sensor
- 130: data processing device

## Claims

1. Logic circuit (1), comprising:
a plurality of input contacts (2);
a sub-circuit (5) for signal edge detection, the sub-circuit (5) having a single signal input (4), the single signal input (4) in electrical contact with each of the plurality of input contacts (2), wherein
the sub-circuit (5) is configured to produce an output signal (6) in response to a signal edge at the single signal input (4);
**characterised by**
a respective high-pass filter (3) electrically connected between each of the input contacts (2) and the single signal input (4).

2. Logic circuit (1) according to claim 1,
wherein each respective high-pass filter (3) is realised by a capacitive coupling between the respective input contact (2) and the single signal input (4).

3. Logic circuit (1) according to claim 1 or 2, wherein the logic circuit (1) is configured to achieve a pre-defined decay-time (44) of each signal (42, 43) at the single signal input (4).

4. Restraint control system (110) for a vehicle (100) for triggering one or more restraints for a passenger in case of an emergency, the restraint control system (110) including a logic circuit (1) according to one of the claims 1 to 3, the restraint control system (110) configured to trigger at least one of the one or more restraints in response to an output signal (6) produced by the sub-circuit (5) of the logic circuit (1).

5. Vehicle (100)
**characterised by**
a restraint control system (110) according to claim 4.

6. Vehicle (100) according to claim 5, wherein the vehicle (100) includes a plurality of sensors (121, 122), and each input contact (2) of the logic circuit (1) of the restraint control system (110) is coupled to at least one of the plurality of sensors (121, 122) in such a way that the respective input contact (2) can receive signals in response to data captured by the at least one of the plurality of sensors (121, 122).

7. Vehicle (100) according to claim 6, wherein one or more sensors (122) of the plurality of sensors are coupled to one or more of the input contacts (2) of the logic circuit (1) via a data processing device (130), the data processing device (130) configured to receive data from the one or more sensors (122), process the data, and produce a signal to the one or more of the input contacts (2) of the logic circuit (1) in dependence on the processed data.
